# EUROPÄISCHE PATENTANMELDUNG

(11) **EP 1 677 232 A1**
(43) Veröffentlichungstag der Anmeldung: **05.07.2006**
(21) Anmeldenummer: 04405795.8
(22) Anmeldetag: 22.12.2004
(51) Int. Cl.: G06K 19/077

(54) **Datenträger und Verfahren zur Herstellung eines Datenträgers**

(71) Anmelder: Trüb AG, CH-5001 Aarau (CH)
(72) Erfinder: Christen, Paul, 5000 Aarau (CH); Hahn, Roland, 4600 Olten (CH)
(74) Vertreter: Groner, Manfred

(57) **Zusammenfassung**

Der Datenträger weist ein in ein Kartenkörper (2) eingesetztes elektronisches Modul (8) auf. Dieses ist in eine Ausnehmung (7) des Kartenkörpers (2) eingesetzt. Die Ausnehmung ist (7) mit einem Füllstoff (12) verschlossen. Das elektronische Modul (8) ist in eine gummielastische Masse (11) eingebettet, die in der genannten Ausnehmung (7) von einem im Wesentlichen härteren Füllstoff (12) überdeckt ist. Das elektronische Modul (8) ist gegen eine mechanische Beschädigung besser geschützt. Trotzdem ist der Datenträger kostengünstig herstellbar.

## Beschreibung

Die Erfindung betrifft einen Datenträger mit einem in einen Kartenkörper eingesetzten Chip bzw. elektronischen Modul, wobei der Chip bzw. das Modul in eine Ausnehmung eingesetzt und diese Ausnehmung mit einem Füllstoff verschlossen ist.

Datenträger mit einem eingebauten elektronischen Chip, sind seit langem bekannt. Der elektronische Chip, auch Mikrokontroller oder Memory-Chip genannt, kann als solcher direkt oder in ein Modul verpackt eingebaut sein. Zum Stand der Technik wird hier beispielsweise auf die DE 198 48 712 A, DE 197 10 656, US 5,164,144, US 5,894,006, WO 00/30031 und die WO 03/03433 des Anmelders hingewiesen. Bei diesen Datenträgern wird der Chip oder das elektronische Modul jeweils in einen Füllstoff eingebettet. Es besteht nun die Gefahr, dass der eingebaute Chip durch eine äussere Krafteinwirkung beschädigt oder zerstört wird. Ein beschädigter Chip wäre nicht mehr brauchbar und müsste ersetzt werden.

Durch die EP 1 013 472 ist ein Datenträger bekannt geworden, bei welchem die genannte Ausnehmung nicht mit einem Füllstoff gefüllt ist. Der Chip ist hier in einen Rahmen aus Keramik eingebaut und auf einem elastischen Teil gelagert. Der Rahmen aus Keramik soll verhindern, dass der Chip deformiert wird. Eine Krafteinwirkung auf den Datenträger soll sich dadurch nicht unmittelbar auf den Chip auswirken.

Der Erfindung liegt die Aufgabe zugrunde, einen Datenträger der genannten Art zu schaffen, bei dem der Chip bzw. das elektronische Modul gegen äussere Krafteinwirkungen noch wirksamer geschützt ist und der trotzdem kostengünstig in Serie hergestellt werden kann.

Die Aufgabe ist bei einem gattungsgemässen Datenträger dadurch gelöst, dass der Chip oder das elektronische Modul in eine gummielastische Masse eingebettet ist und dass diese Masse in der genannten Ausnehmung von einem wesentlich härteren Füllstoff überdeckt ist. Beim erfindungsgemässen Datenträger ist das elektronische Modul in eine gummielastische Masse eingebettet und dadurch gegen Schock gesichert. Gegen aussen ist das elektronische Modul aber dennoch durch den harten Füllstoff geschützt. Die gummielastische Masse und der wesentlich härtere Füllstoff können durch Ausgiessen der Ausnehmung sehr kostengünstig und in Serie hergestellt werden. Der Datenträger kann als Karte, beispielsweise Wertkarte oder Ausweiskarte als auch als Datenseite für Pässe, so genannte Datapage realisiert werden.

Nach einer Weiterbildung der Erfindung ist vorgesehen, dass der Füllstoff ein thermoplastischer Kunststoff ist. Dieser kann insbesondere im Schmelzgussverfahren sehr kostengünstig in den freien Raum der Ausnehmung eingebracht und insbesondere eingespritzt werden.

Die gummielastische Masse und der Füllstoff sind vorzugsweise so ausgebildet, dass sie sich fest miteinander verbinden.

Der Füllstoff ist vorzugsweise so in die Ausnehmung eingebracht, dass er mit einer Oberfläche des Kartenkörpers und insbesondere einer Folie bündig ist. Eine solche Bündigkeit kann beispielsweise in einer Giessform hergestellt werden. Dieses Ausgiessen der Ausnehmung ist vorzugsweise im Wesentlichen der letzte Schritt in der Herstellung des Datenträgers. Damit kann vermieden werden, dass nach dem Ausgiessen der Ausnehmung und damit nach dem Einbringen des elektronischen Moduls der Datenträger durch fehlerhafte weitere Verfahrensschritte ausgeschieden werden muss.

Der Datenträger ist gemäss einer Weiterbildung der Erfindung eine sogenannte Datapage. Diese besteht vorzugsweise aus wenigstens zwei Folien und einer herausragenden flexiblen Schicht, insbesondere einem Textil, mit dem die Datapage in ein Büchlein, insbesondere in einen Pass eingenäht oder sonstwie befestigt ist.

Nach einer Weiterbildung der Erfindung ist das elektronische Modul in ein Schutzelement eingesetzt, das ringförmig ausgebildet ist und das elektronische Modul umgibt. Ein solches Schutzelement ergibt einen weiteren Schutz gegen eine Beschädigung des Chips bzw. des elektronischen Moduls.

Die Erfindung betrifft zudem ein Verfahren zur Herstellung eines Datenträgers. Bei diesem Verfahren wird das elektronische Modul in eine Ausnehmung des Kartenkörpers eingesetzt. Anschliessend wird diese Ausnehmung teilweise mit einer gummielastischen Masse ausgegossen, so dass das elektronische Modul in diese gummielastische Masse eingebettet ist. Anschliessend wird der verbleibende Raum der Ausnehmung mit einem wesentlich härteren Füllstoff ausgegossen.

Weitere vorteilhafte Merkmale ergeben sich aus den abhängigen Patentansprüchen, der nachfolgenden Beschreibung sowie der Zeichnung.

Ausführungsbeispiele der Erfindung werden nachfolgend anhand der Zeichnung näher erläutert. Es zeigen:
- Fig. 1 - 4: anhand eines Teilquerschnitts einzelne Phasen bei der Herstellung eines erfindungsgemässen Datenträgers,
- Figur 5: eine Draufsicht auf einen Abschnitt eines erfindungsgemässen Datenträgers,
- Figur 6: ein weiterer Teilquerschnitt durch einen erfindungsgemässen Datenträger.
- Figur 7: einen Teilschnitt durch einen Datenträger entlang der Linie VII-VII der Fig. 8 und
- Figur 8: eine Teilansicht des Datenträgers nach Fig. 7.

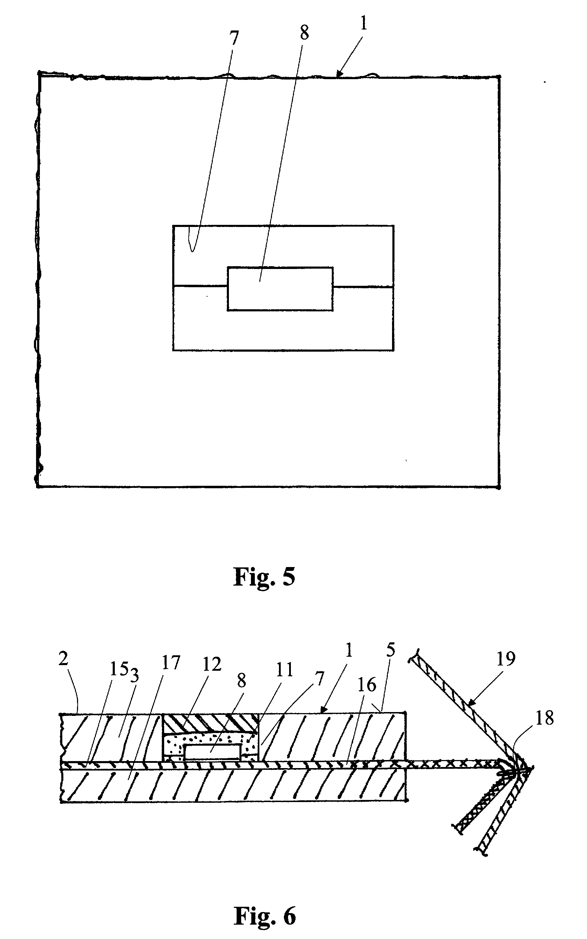

Der in Fig. 6 teilweise gezeigte Datenträger 1 ist beispielsweise eine so genannte Datapage, die in ein hier nicht weiter gezeigtes Büchlein und insbesondere in ein Passbüchlein 19 eingebunden ist. Der Datenträger 1 kann aber auch eine Karte, insbesondere eine sogenannte Smart Card sein. Der Datenträger 1 enthält hier nicht gezeigte Merkmale für die Identifikation des Inhabers des Passbüchleins 19 sowie hier ebenfalls nicht gezeigte Sicherheitsmerkmale, beispielsweise ein Hologramm und dergleichen. Diese Merkmale sind beispielsweise auf einer Oberseite 5 eines Kartenkörpers 2 angeordnet. Der Kartenkörper 2 besteht beispielsweise aus Schichten bzw. Folien 3, 15 und 17, die durch Laminieren fest miteinander verbunden sind. Der Kartenkörper 2 kann ein- oder mehrschichtig sein. Zwischen die Schichten 3 und 17 ist zudem ein Textil 16 oder eine andere geeignete flexible Folie oder Schicht einlaminiert. Das Textil 16 dient dazu, den Datenträger 2 in das Büchlein 19 einzubinden. Das Einbinden erfolgt hier beispielsweise mit einem Faden 18. Beim Laminieren der Folien 13 und 17 verbinden sich diese durch die Öffnungen des Textils 16 hindurch unlösbar miteinander. Das Textil 16 kann sich gemäss Fig. 6 über einen Teilbereich des Datenträgers 2 oder auch über diesen ganzen Bereich erstrecken. Der Datenträger 2 ist damit unlösbar mit dem Textil 16 verbunden.

Im Kartenkörper 2 des Datenträgers 1 ist ein Chip oder ein elektronisches Modul 8 eingebettet. Dieser elektronische Chip bzw. das Modul 8 kann mit einer hier nicht gezeigten Antenne verbunden sein, welche beispielsweise zwischen den Schichten 3 und 4 eingelegt ist. Solche Antennen sind dem Fachmann gut bekannt. Der Chip bzw. das elektronische Modul 8 enthält beispielsweise Daten zur Identifikation der Person, welche Inhaber des Datenträgers 1 ist. Die Daten können berührungslos ablesbar sein.

Der Chip bzw. das elektronische Modul 8 ist in eine gummielastische Masse 11 eingebettet, mit welcher eine Ausnehmung 7 der Folie 3 wenigstens teilweise ausgegossen ist. Über dieser gummielastischen Masse 11 befindet sich ein weiterer Füllstoff 12, der wesentlich härter ist als die gummielastische Masse 11. Der härtere Füllstoff 12 ist ebenfalls in die Ausnehmung 7 eingegossen. Die gummielastische Masse 11 und der härtere Füllstoff 12 sind chemisch fest miteinander verbunden. Zudem ist die gummielastische Masse 11 mit den Schichten 3 und 15 fest verbunden. Der härtere Füllstoff 12 ist mit der Folie 3 fest verbunden und zudem vorzugsweise aussenseitig bündig mit der Oberseite 5 der Folie 3. Die Ausnehmung 7 ist insbesondere eine Ausstanzung der Folie 3. Die Ausnehmung 7 kann aber auch eine Ausfräsung oder dergleichen sein. Sie kann sich auch in den Bereich der Schicht 15 und sogar in den Bereich der Folie 17 erstrecken. Wie ersichtlich, ist die Ausnehmung 7 breiter und auch höher als der Chip bzw. das elektronische Modul 8. Der Datenträger 1 kann auch zwei oder mehrere Chips bzw. elektronische Module 8 in einer oder mehreren Ausnehmungen 7 aufweisen. Der härtere Füllstoff 12 kann wie erwähnt einen Bereich der Oberseite 5 bilden. Er kann aber beispielsweise mit einem hier nicht gezeigten Schutzlack oder einer Deckfolie abgedeckt sein.

Die in die Ausnehmung 7 eingebrachte Füllung besteht somit aus einer gummielastischen Masse 11 und einem über dieser angeordneten wesentlich härteren Füllstoff 12. Die Füllung ist somit zweischichtig, wobei grundsätzlich auch mehr als zwei Schichten denkbar sind.

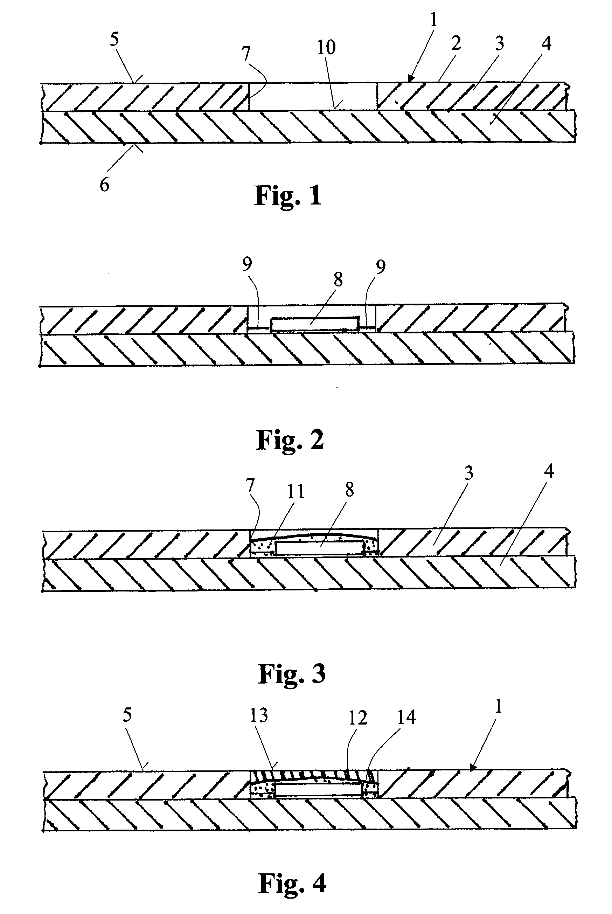

Anhand der Fig. 1 bis 5 wird nachfolgend ein bevorzugtes Verfahren zur Herstellung des erfindungsgemässen Datenträgers 1 näher erläutert.

Vor dem Montieren des Datenträgers 8 wird der in Fig. 1 gezeigte rohe Datenträger 1 hergestellt. Bevor die beiden Folien 3 und 4 durch Laminieren miteinander verbunden werden, wird in die Folie 3 die Ausnehmung 7 durch Ausstanzen oder Ausfräsen hergestellt. Zwischen den beiden Folien 3 und 4 kann gemäss Fig. 6 die Schicht 15 und das Textil 16 einlaminiert werden. In den Fig. 1 bis 4 sind die Schichten 15 und das Textil 16 weggelassen. Alternativ und vorzugsweise wird die Ausnehmung 7 in den fertig hergestellten Kartenkörper 2 eingearbeitet. Nach der Herstellung des Kartenkörpers 2 wird dieser durch Anbringen der vorgesehenen und hier nicht näher gezeigten Sicherheitsmerkmale und weiterer Daten fertiggestellt. Diese Daten werden einer Qualitätskontrolle unterzogen und nicht befriedigende Datenträger 1 werden ausgeschieden. Es werden somit lediglich Datenträger 1 weiterverarbeitet, welche einer Kontrolle bzw. vorbestimmten Qualitätsmerkmalen genügen.

Zwischen den Folien 3 und 4 kann eine hier nicht gezeigte Antenne angeordnet sein.

Ist der Datenträger 1 wie oben erwähnt im Wesentlichen fertiggestellt, so wird in die Ausnehmung 7 ein Chip oder ein elektronisches Modul 8 eingesetzt und beispielsweise mit Lötstellen 9 mit der genannten Antenne verbunden. Der Chip bzw. das elektronische Modul 8 kann zudem beispielsweise mit einem Kleber mit der Folie 4 verbunden werden.

Nach dem Einsetzen und Verbinden des Chips bzw. des elektronischen Moduls 8 wird in die Ausnehmung 7 eine gummielastische Masse 11 eingegossen, insbesondere eingespritzt. Diese Masse 11 umgibt den Chip bzw. das elektronische Modul 8, wie in Fig. 3 gezeigt. Die gummielastische Masse 11 wird beispielsweise mit Hilfe einer hier nicht gezeigten Giessform in die Ausnehmung 7 eingespritzt. Der Druck ist hierbei vergleichsweise klein und beträgt beispielsweise 1 bis 7 bar. Die Temperatur der gummielastischen Masse 11 beim Einspritzen ist ebenfalls vergleichsweise tief und beträgt beispielsweise weniger als 300° C. Dies ermöglicht ein schonendes Einbetten des Chips bzw. des elektronischen Moduls 8. Wie ersichtlich, wird die Ausnehmung 7 nicht vollständig mit der gummielastischen Masse 11 ausgegossen.

Nach dem Eingiessen der gummielastischen Masse 11 wird in die Ausnehmung 7 ein Füllstoff 12 eingebracht und insbesondere eingespritzt. Dieser Füllstoff 12 ist vorzugsweise ein thermoplastischer Kunststoff, und insbesondere ein Schmelzkleber, der nach dem Aushärten wesentlich härter ist als die gummielastische Masse 11. Wie ersichtlich, ist die Oberseite der gummielastischen Masse 11 vollständig vom Füllstoff 12 abgedeckt. Die Oberseite 13 des Füllstoffs 12 ist vorzugsweise bündig mit der Oberseite 5. Die Oberseite 5 kann mit einer Schutzschicht, beispielsweise einem Lack versehen werden, welcher ebenfalls den Füllstoff 12 überdeckt. Eine solche hier nicht gezeigte Schutzschicht oder eine geeignete Deckfolie kann hier aber auch weggelassen sein.

Die Folien 3 und 4 und allenfalls noch weitere hier nicht gezeigte Folien sind beispielsweise aus Polycarbonat oder einem anderen geeigneten Kunststoff hergestellt.

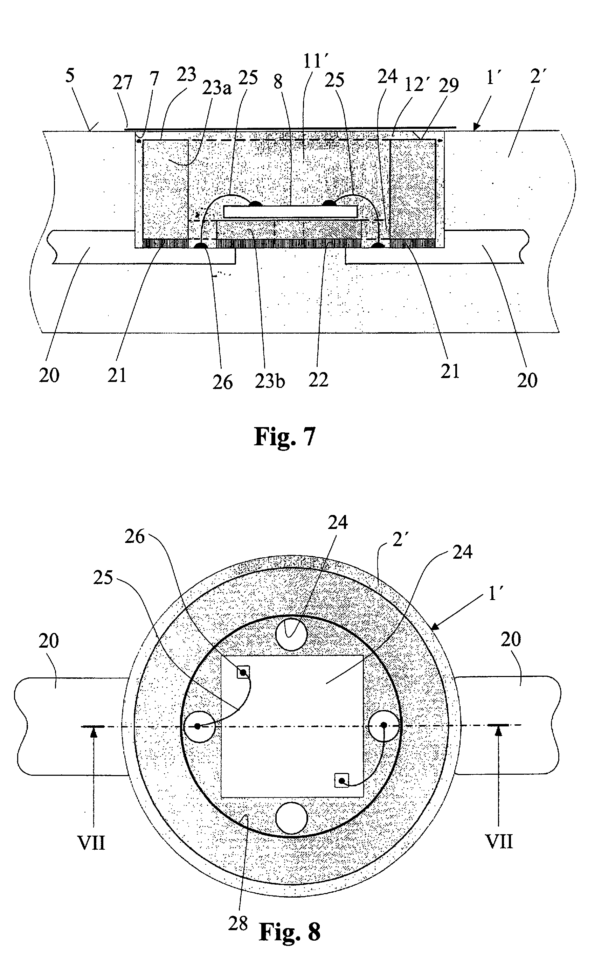

Die Fig. 7 und 8 zeigen einen erfindungsgemässen Datenträger 1', der ebenfalls eine Datapage, eine Wert- oder Ausweiskarte, eine Smart Card oder dergleichen ist. Der Datenträger 1' besitzt einen Kartenkörper 2', der aus mehreren hier nicht gezeigten Folien hergestellt sein kann. In den Kartenkörper 2' ist eine Ausnehmung 7 eingearbeitet, beispielsweise durch Stanzen, Bohren oder Fräsen. Die Ausnehmung 7 ist bei diesem Ausführungsbeispiel kreisrund, es sind aber auch beispielsweise polygonale, ovale und andere Formen denkbar.

In die Ausnehmung 7 ist ein Schutzelement 23 eingesetzt, das eine ringförmige Seitenwandung 23a sowie eine ebene Bodenwandung 23b besitzt. Denkbar ist auch ein Schutzelement, bei dem die Bodenwandung 23b weggelassen ist. Die Seitenwandung 23a ist gemäss Fig. 8 kreisrund, es sind hier aber auch andere Formen, beispielsweise eine polygonale Form möglich. Das Schutzelement 23 besteht aus einem vergleichsweise harten Werkstoff, beispielsweise aus Metall, Kunststoff oder Keramik. Das Schutzelement 23 ist auf einer Schicht 21 angeordnet. Diese Schicht 21 ist beispielsweise eine Klebeschicht, welche das Schutzelement 23 fest mit dem Kartenkörper 2' verbindet. Die Schicht 21 kann so ausgebildet sein, dass sie elektrisch isolierend und/oder dämpfend ist. Wie ersichtlich, ist die Höhe des Schutzelements 23 so bemessen, dass eine Oberseite 29 des Schutzelements 23 sich unterhalb der Oberseite 5 des Datenträgers 1' befindet.

In das Schutzelement 23 ist der Chip oder das Modul 8 von oben eingesetzt und unmittelbar über der Bodenwandung 23b angeordnet. Für den elektrischen Anschluss des Chips bzw. des elektronischen Moduls 8 mit einer in den Kartenkörper 2' eingebetteten Antenne 20 weist das Schutzelement 23 mehrere Durchgänge 24 auf. Von den vier in Fig. 8 gezeigten Durchgängen 24 sind zwei für diese Anschlüsse benutzt. Grundsätzlich können auch lediglich zwei solche Durchgänge 24 vorgesehen sein. Der elektrische Anschluss erfolgt hier durch zwei Leitungen 25, die mit Verbindungen, beispielsweise Lötstellen mit dem Chip bzw. dem elektronischen Modul 8 sowie der Antenne 20 verbunden sind. Die Antenne kann in an sich bekannter Weise geätzt, gedruckt, gelegt, gewickelt und mit so genannten Pads versehen sein.

Bei der Herstellung wird das Schutzelement 23 in die Ausnehmung 7 eingesetzt und beispielsweise mit der Schicht 21 mit dem Kartenkörper 2' verbunden. Der Chip bzw. das elektronische Modul 8 kann bereits auf dem Schutzelement 23 angeordnet sein. Denkbar ist aber auch ein nachträglicher Einbau des Chips bzw. des elektronischen Moduls 8. Ist der Chip bzw. das elektronische Modul 8 mit der Antenne 20 verbunden, so wird in die Ausnehmung 7 eine gummielastische Masse 11' bei niedrigem Druck und niedriger Temperatur eingespritzt oder eingepumpt. Diese gummielastische Masse 11' ist beispielsweise eine Silikonpaste. Es können hier auch mehrere solche gummielastische Schichten 11' schicht- oder lagenweise eingespritzt bzw. eingepumpt werden. Die Ausnehmung 7 wird hierbei vorzugsweise jedoch nicht vollständig ausgefüllt. In den noch nicht ausgefüllten Bereich wird nun eine weitere Schicht 12' aufgetragen, beispielsweise eingespritzt oder eingepumpt. Diese Schicht 12' wird durch einen Füllstoff gebildet, der wesentlich härter ist. Beispielsweise ist dieser Füllstoff ein thermoplastischer Kunststoff. Dieser wird als flüssiger Kunststoff in die Ausnehmung 7 eingegossen, um diese Ausnehmung 7 im Wesentlichen vollständig, und vorzugsweise bis zur Oberseite 5 auszufüllen. Die Schicht 12' kann ebenfalls aus mehreren Schichten und unterschiedlichen Kunststoffen bestehen.

Der Chip bzw. das elektronische Modul 8 ist damit gegen eine Beschädigung weitgehend geschützt. Insbesondere ist der Chip bzw. das elektronische Modul 8 gegen Krafteinwirkung, Erschütterung, Schock und dergleichen geschützt.

Um dem Chip bzw. das elektronische Modul 8 noch weitergehend gegen Missbrauch und Fälschungsangriffe zu schützen, kann die Ausnehmung 7 mit einem Sicherheitselement, beispielsweise einer holographischen Folie 27 abgedeckt sein. Die Folie 27 kann sich über den gesamten Bereich der Schicht 12' erstrecken. Grundsätzlich ist aber auch eine Ausführung denkbar, bei welcher die Folie 27 lediglich einen Teilbereich der Schicht 12' abdeckt. Die Folie 27 kann auch durch eine Prägung, ein Label oder einen Druck ersetzt werden. Diese Elemente können auch in Kombination miteinander vorhanden sein.

### Bezugszeichenliste

- 1: Datenträger
- 2: Kartenkörper
- 3: Folie
- 4: Folie
- 5: Oberseite
- 6: Unterseite
- 7: Ausnehmung
- 8: Chip oder elektronisches Modul
- 9: Verbindung
- 10: Bodenfläche
- 11: gummielastische Masse
- 12: Füllstoff
- 13: Oberseite Füllstoff
- 14: Verbindungsstelle
- 15: Schicht (Folienschicht)
- 16: Textil
- 17: Schicht (Folienschicht)
- 18: Faden
- 19: Büchlein
- 20: Antenne
- 21,: Schicht (Klebeschicht)
- 22: Schicht (Klebeschicht)
- 23: Schutzelement
- 23a: Seitenwandung
- 23b: Bodenwandung
- 24: Durchgang
- 25: Leitung
- 26: Verbindung
- 27: Folie (Schutzfolie, Sicherheitsfolie)
- 28: Ausnehmung
- 29: Oberseite

## Patentansprüche

1. Datenträger mit einem in einen Kartenkörper (2) eingesetzten Chip oder elektronischen Modul (8), wobei der Chip bzw. das Modul (8) in eine Ausnehmung (7) eingesetzt und diese Ausnehmung (7) mit einem Füllstoff (12) verschlossen ist, **dadurch gekennzeichnet, dass** der Chip bzw. das elektronische Modul (8) in eine gummielastische Masse (11) eingebettet ist und dass diese Masse (11) in der genannten Ausnehmung (7) von einem wesentlich härteren Füllstoff (12) überdeckt ist.

2. Datenträger nach Anspruch 1, **dadurch gekennzeichnet, dass** die Ausnehmung (7) insbesondere eine Ausfräsung des Kartenkörpers (2) ist.

3. Datenträger nach Anspruch 1 oder 2, **dadurch gekennzeichnet, dass** der härtere Füllstoff (12) ein thermoplastischer Kunststoff ist.

4. Datenträger nach einem der Ansprüche 1 bis 3, **dadurch gekennzeichnet, dass** der härtere Füllstoff (12) ein Schmelzklebstoff ist.

5. Datenträger nach einem der Ansprüche 1 bis 4, **dadurch gekennzeichnet, dass** die gummielastische Masse (11) und der härtere Füllstoff (12) chemisch fest miteinander verbunden sind.

6. Datenträger nach einem der Ansprüche 1 bis 5, **dadurch gekennzeichnet, dass** die gummielastische Masse (11) und der härtere Füllstoff (12) in die Ausnehmung (7) eingegossen oder eingespritzt sind.

7. Datenträger nach einem der Ansprüche 1 bis 6, **dadurch gekennzeichnet, dass** die Ausnehmung (7) eine Ausstanzung einer Folie (3) des Kartenkörpers ist.

8. Datenträger nach einem der Ansprüche 1 bis 7, **dadurch gekennzeichnet, dass** der härtere Füllstoff (12) bündig zu einer Oberseite (5) des Kartenkörpers (2) ist.

9. Datenträger nach einem der Ansprüche 1 bis 8, **dadurch gekennzeichnet, dass** der Kartenkörper (2) aus wenigstens zwei miteinander verbundenen Folien (3,4) besteht und dass die Ausnehmung (7) eine Vertiefung in einer dieser Folien (3) ist.

10. Datenträger nach einem der Ansprüche 1 bis 9, **dadurch gekennzeichnet, dass** der Datenträger (1) eine Smart Card oder eine Datenseite insbesondere eines Passes ist.

11. Datenträger nach einem der Ansprüche 1 bis 10, **dadurch gekennzeichnet, dass** der Chip bzw. das elektronische Modul (8) in ein Schutzelement (23) eingesetzt ist.

12. Datenträger nach Anspruch 11, **dadurch gekennzeichnet, dass** das Schutzelement (23) ring- oder büchsenförmig ausgebildet ist.

13. Datenträger nach Anspruch 11 oder 12, **dadurch gekennzeichnet, dass** das Schutzelement (23) auf einer Schicht (21) angeordnet ist, die klebend, isolierend und/oder dämpfend ist.

14. Datenträger nach einem der Ansprüche 1 bis 13, **dadurch gekennzeichnet, dass** auf die Oberseite (5) des Datenträgers im Bereich des härteren Füllstoffs (12,12') ein Sicherheitselement (27) angeordnet ist, welches den Chip bzw. das elektronische Modul (8) schützt.

15. Verfahren zur Herstellung eines Datenträgers nach Anspruch 1, **dadurch gekennzeichnet, dass** in eine Ausnehmung (7) eines Kartenkörpers (2) ein Chip bzw. ein elektronisches Modul (8) eingesetzt wird, dass die Ausnehmung (7) wenigstens teilweise mit einer gummielastischen Masse (11) ausgegossen und damit der Chip bzw. das elektronische Modul (8) eingegossen wird und dass in den verbleibenden Raum der Ausnehmung (7) ein Füllstoff (12) eingebracht wird, der wesentlich härter ist als die gummielastische Masse (11).

16. Verfahren nach Anspruch 15, **dadurch gekennzeichnet, dass** wenigstens der Füllstoff (12) ein thermoplastischer Kunststoff und insbesondere ein Schmelzklebstoff ist.

17. Verfahren nach Anspruch 15 oder 16, **dadurch gekennzeichnet, dass** die gummielastische Masse (11) und/oder der Füllstoff (12) mit vergleichsweise niedrigem Druck von beispielsweise 1 bis 7 bar in die Ausnehmung (7) eingespritzt wird bzw. werden.

18. Verfahren nach Anspruch 17, **dadurch gekennzeichnet, dass** die gummielastische Masse (11) und/oder der Füllstoff (12) bei einer vergleichsweise geringen Temperatur, insbesondere bei einer Temperatur kleiner als 300° C eingegossen bzw. eingespritzt werden.

19. Verfahren nach einem der Ansprüche 15 bis 18, **dadurch gekennzeichnet, dass** die Ausnehmung (7) in einen fertig laminierten Kartenkörper (2), insbesondere durch Ausfräsen eingearbeitet wird.

## Geänderte Patentansprüche

### Geänderte Patentansprüche gemäss Regel 86(2) EPÜ.

**1.** Datenträger mit einem in einen Kartenkörper (2) eingesetzten Chip oder elektronischen Modul (8), wobei der Chip bzw. das Modul (8) in eine Ausnehmung (7) eingesetzt und diese Ausnehmung (7) mit einem Füllstoff (12) verschlossen ist, **dadurch gekennzeichnet, dass** der Chip bzw. das elektronische Modul (8) in eine gummielastische Masse (11) eingebettet ist und dass diese Masse (11) in der genannten Ausnehmung (7) von dem Füllstoff (12), der wesentlich härter ist als die gummielastische Masse, überdeckt ist.

**2.** Datenträger nach Anspruch 1, **dadurch gekennzeichnet, dass** die Ausnehmung (7) eine Ausfräsung des Kartenkörpers (2) ist.

**3.** Datenträger nach Anspruch 1 oder 2, **dadurch gekennzeichnet, dass** der härtere Füllstoff (12) ein thermoplastischer Kunststoff ist.

**4.** Datenträger nach einem der Ansprüche 1 bis 3, **dadurch gekennzeichnet, dass** der härtere Füllstoff (12) ein Schmelzklebstoff ist.

**5.** Datenträger nach einem der Ansprüche 1 bis 4, **dadurch gekennzeichnet, dass** die gummielastische Masse (11) und der härtere Füllstoff (12) chemisch miteinander verbunden sind.

**13.** Datenträger nach Anspruch 11 oder 12, **dadurch gekennzeichnet, dass** das Schutzelement (23) auf einer Schicht (21) angeordnet ist, die klebend, elektrisch isolierend und/oder dämpfend ist.

**14.** Datenträger nach einem der Ansprüche 1 bis 13, **dadurch gekennzeichnet, dass** auf die Oberseite (5) des Datenträgers im Bereich des härteren Füllstoffs (12,12') ein sicherheitselement (27) angeordnet ist, welches den Chip bzw. das elektronische Modul (8) schützt.

**15.** Verfahren zur Herstellung eines Datenträgers nach Anspruch 1, wobei in eine Ausnehmung (7) eines Kartenkörpers (2) ein Chip bzw. ein elektronisches Modul (8) eingesetzt und die Ausnehmung (7) ausgegossen wird, **dadurch gekennzeichnet, dass** die Ausnehmung (7) wenigstens teilweise mit einer gummielastischen Masse (11) ausgegossen und damit der Chip bzw. das elektronische Modul (8) eingegossen wird und dass in den verbleibenden Raum der Ausnehmung (7) ein Füllstoff (12) eingebracht wird, der wesentlich härter ist als die gummielastische Masse (11), nach dem Aushärten.

**16.** Verfahren nach Anspruch 15, **dadurch gekennzeichnet, dass** wenigstens der Füllstoff (12) ein thermoplastischer Kunststoff und insbesondere ein Schmelzklebstoff ist.

**17.** Verfahren nach Anspruch 15 oder 16, **dadurch gekennzeichnet, dass** die gummielastische Masse (11) und/oder der Füllstoff (12) mit einem Druck von 1 bis 7 bar in die Ausnehmung (7) eingespritzt wird bzw. werden.

**18.** Verfahren nach Anspruch 17, **dadurch gekennzeichnet, dass** die gummielastische Masse (11) und/oder der Füllstoff (12) bei einer Temperatur kleiner als 300° C eingegossen bzw. eingespritzt werden.

**19.** Verfahren nach einem der Ansprüche 15 bis 18, **dadurch gekennzeichnet, dass** die Ausnehmung (7) in einen fertig laminierten Kartenkörper (2), insbesondere durch Ausfräsen eingearbeitet wird.
